# EUROPEAN PATENT SPECIFICATION

(11) **EP 2 824 702 B1**
(45) Date of publication and mention of the grant of the patent: **03.08.2016**
(21) Application number: 14169976.9
(22) Date of filing: 27.05.2014
(51) Int. Cl.: H01L 23/24, H01L 21/56, H05K 1/02, H01L 23/367, H01L 23/42, H01L 23/40, H01L 23/373, H05K 3/00, H05K 3/28, H05K 7/20

(54) **Heat radiation plate and submarine apparatus**
Wärmestrahlungsplatte und Unterseebootvorrichtung
Plaque de rayonnement thermique et appareil sous-marin

(30) Priority: 11.07.2013 JP 2013145831
(43) Date of publication of application: 14.01.2015
(73) Proprietor: FUJITSU LIMITED, Kawasaki-shi, Kanagawa 211-8588 (JP)
(72) Inventor: Yoshizumi, Takahisa, Fukuoka-shi, Fukuoka 814-8588 (JP); Hoshiyama, Naoto, Kanagawa, 211-8588 (JP)
(74) Representative: Hoffmann Eitle

(56) References cited:
- EP-A2- 1 533 839
- WO-A1-2006/118031
- WO-A2-2008/000551
- WO-A2-2010/018466
- GB-A- 2 485 830
- US-A1- 2012 146 232

## Description

### FIELD

The embodiments discussed herein are related to a heat radiation plate and a submarine apparatus.

### BACKGROUND

Typically, an electronic apparatus in which an electronic component that generates heat on a circuit board, hereinafter referred to as a "heating component", is cooled by convective heat transferred with a fan is utilized. In an electronic apparatus used under the sea, hereinafter referred to as a "submarine apparatus", such as a submarine repeater, no fan has been employed so as to cool an electronic component because of a short lifetime of a fan motor or difficulty in being exchanged when failure occurs. Thus, in such a submarine apparatus, the heat of an electronic component may be radiated toward the outside of the housing through heat conduction, which is heat transmission inside an object. For example, thermally-conductive resin, which has high flowability and is unlikely to cause hazardous gas, such as sulfur, is used as a member for the heat conduction.

When the submarine apparatus uses thermally-conductive resin so as to cool a heating component, for example, the heating component is arranged on one surface of a circuit board and other electronic components are arranged on the other surface of the circuit board. The heating component is immersed in the thermally-conductive resin filled in a pool on a heat-transfer plate that faces the circuit board and thus, the heat of the heating component is radiated to the heat-transfer plate via the thermally-conductive resin.

When the number of heating components is small, such as one, a component with a large height, such as an insertion mount device (IMD) component, is used as the heating component and the component is arranged in an end portion of the circuit board in the submarine apparatus. In this case, since the number of heating components is small, the area of the pool for the thermally-conductive resin is not desired to be large, and because of the large height of the heating component, the heating component may be certainly immersed in the thermally-conductive resin without paying much attention to whether or not the thermally-conductive resin is horizontally accumulated in the pool. Further, since the heating component is arranged in the end portion of the circuit board as described above, a person who manufactures the submarine apparatus may visually check that the heating component is certainly immersed in the thermally-conductive resin even after the circuit board is attached to the heat-transfer plate.

Examples of related art include Japanese Laid-open Patent Publication No. 2001-144449 and Japanese Laid-open Patent Publication No. 2004-222426.

Also, document WO 2008/000551 A2 discloses a heat radiation plate as defined in the preamble of appended claim 1.

Document GB 2 485 830 A discloses a method for forming a multi-chip integrated circuit package, which includes electrically conductive pillars.

Reference can also be made to the respective contents of documents WO 2006/118031 A1, WO 2010/018466 A2, US 2012/146232 A1 and EP 1 533 839 A2.

### SUMMARY

Accordingly, it is an object in one aspect of the invention to provide a heat radiation plate and a submarine apparatus that enable visual check on that thermally-conductive resin contains no air bubbles and is horizontally filled to be performed easily and accurately.

A heat radiation plate and a submarine apparatus according to the invention are as defined in the appended claims.

### BRIEF DESCRIPTION OF DRAWINGS

FIG. 1 is a perspective view of the external appearance of a submarine apparatus;
FIG. 2 is an exploded perspective view of a heat radiation unit in the submarine apparatus;
FIG. 3 illustrates how a circuit board of the heat radiation unit is attached to a heat-transfer plate;
FIG. 4A is an enlarged perspective view of a height check portion of a heat-transfer plate according to a first embodiment;
FIG. 4B is an enlarged IVB-IVB cross sectional view of the height check portion of the heat-transfer plate according to the first embodiment;
FIG. 5A is an enlarged perspective view of a height check portion of a heat-transfer plate according to a second embodiment;
FIG. 5B is an enlarged VB-VB cross sectional view of the height check portion of the heat-transfer plate according to the second embodiment;
FIG. 6A is a perspective view of the external appearance of a heat-transfer plate according to a third embodiment;
FIG. 6B is an enlarged perspective view of a height check portion of the heat-transfer plate according to the third embodiment;
FIG. 6C is an enlarged VIC-VIC cross sectional view of the height check portion of the heat-transfer plate according to the third embodiment;
FIG. 7 illustrates how a circuit board is attached to a heat-transfer plate in related art; and
FIG. 8 is a VIII-VIII cross sectional view taken after the circuit board is attached to the heat-transfer plate in the related art.

### DESCRIPTION OF EMBODIMENTS

Because of a recent trend in International Telecommunication Union's Telecommunication Standardization Sector (ITU-T) to treat submarine cables as shared cables for communication and observation, or for another reason, submarine apparatuses are desired to be smaller in size and higher in density and a large number of heating components are mounted on one circuit board. In this case, a large number of heating components smaller in height than IMD components, such as surface mount device (SMD) components, are mounted on the circuit board.

When many heating components are mounted on a circuit board, it may be difficult to provide all of the heating components with pools for the thermally-conductive resin individually. Accordingly, the area of the pool for the thermally-conductive resin may be large and approximately the same as the area of the circuit board. Thus, when the circuit board is attached while the heat-transfer plate is not horizontal, the heating components may fail to be certainly immersed in the thermally-conductive resin. Besides, the increase in the area of the pool may make it very difficult to visually check the contact state after the circuit board is attached, particularly near the center of the circuit board.

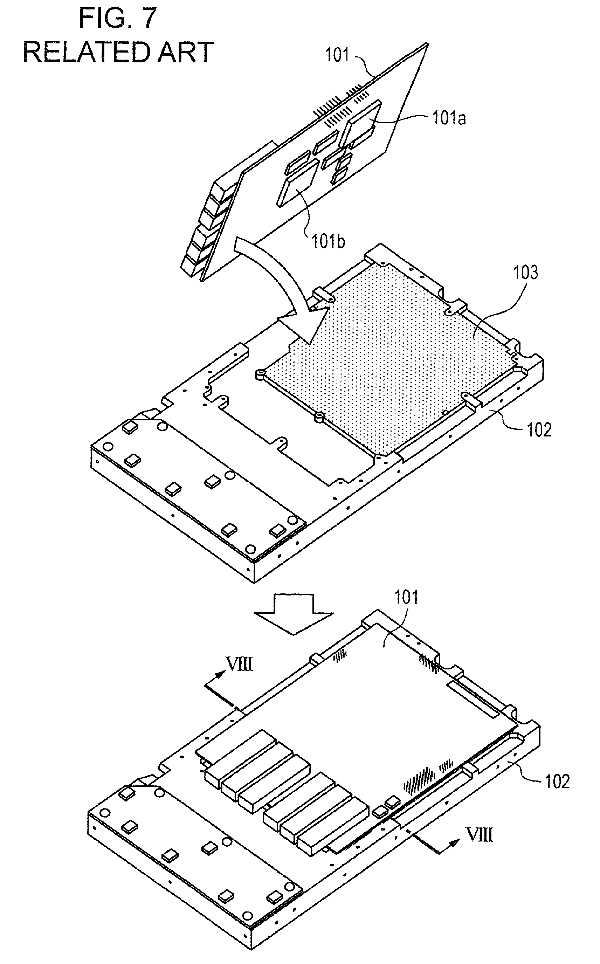

FIG. 7 illustrates how a circuit board 101 is attached to a heat-transfer plate 102. As illustrated in FIG. 7, thermally-conductive resin 103 is poured into a pool of the heat-transfer plate 102 in advance. Thus, when the circuit board 101 is closed toward the heat-transfer plate 102 to be attached, a plurality of heating components 101a and 101b arranged on the circuit board 101 are immersed in the thermally-conductive resin 103 in the pool. As a result, the heating component 101a and 101b are in contact with the thermally-conductive resin 103 and heat may be radiated toward the outside of a housing via the thermally-conductive resin 103 and the heat-transfer plate 102.

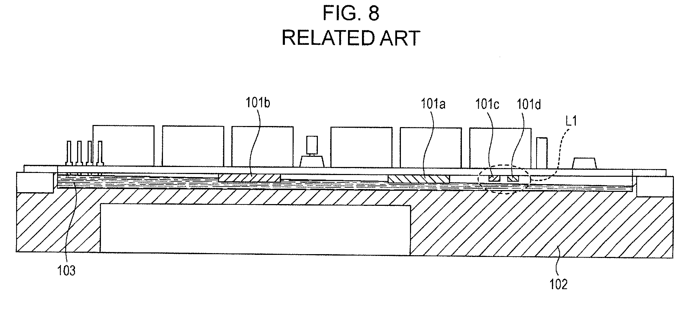

If, however, the thermally-conductive resin 103 is poured into the pool while the heat-transfer plate 102 is tilted, an upper surface of the thermally-conductive resin 103 fails to be horizontal. FIG. 8 is a VIII-VIII cross sectional view of the heat-transfer plate 102, which is taken after the circuit board 101 is attached. As illustrated in FIG. 8, the upper surface of the thermally-conductive resin 103 poured in the pool of the heat-transfer plate 102 may fail to be horizontal. In FIG. 8, the height of the thermally-conductive resin 103 varies such that the thermally-conductive resin 103 is higher on the left side and lower on the right side. As a result, among the heating components 101a and 101b, and heating components 101c and 101d, which are arranged on one surface of the circuit board 101, the heating component 101b on the left side and the heating component 101a with a large height are immersed in the thermally-conductive resin 103. In contrast, as illustrated using surrounding broken lines L1, the heating components 101c and 101d that are arranged on the right side and have small heights are not in contact with the thermally-conductive resin 103 although the heating components 101c and 101d generate heat.

Since particularly the heating components with small heights are less immersed in the thermally-conductive resin than the components with large heights as described above, even a slight tilt of the heat-transfer plate may affect the contact between the heating components and the thermally-conductive resin and decrease the cooling effect. The decrease in the cooling effect may cause breakage of the heating components.

Further, in the above-described cooling method using the thermally-conductive resin, the volume and weight of the thermally-conductive resin are measured before pouring the thermally-conductive resin into the pool, and the thermally-conductive resin may contain an air bubble (air) while being measured or poured. As described above, when the number of heating components is small, such as one, it may be visually checked easily that the heating component is immersed in the thermally-conductive resin even after the circuit board is attached to the heat-transfer plate. In addition, the presence or absence of an air bubble (air) in the thermally-conductive resin may also be checked similarly. However, when a large number of heating components with small heights are mounted on the circuit board, it may be difficult for a person who manufactures the submarine apparatus to visually check that the heating components are immersed in the thermally-conductive resin after the attachment of the circuit board. Besides, it may also be difficult to check the presence or absence of an air bubble.

Embodiments of a heat radiation plate and a submarine apparatus, which enable visual check on that thermally-conductive resin contains no air bubbles and is horizontally filled to be performed easily and accurately, are described in detail below with reference to the drawings. The heat radiation plate and the submarine apparatus of the present application are not limited by the embodiments described below.

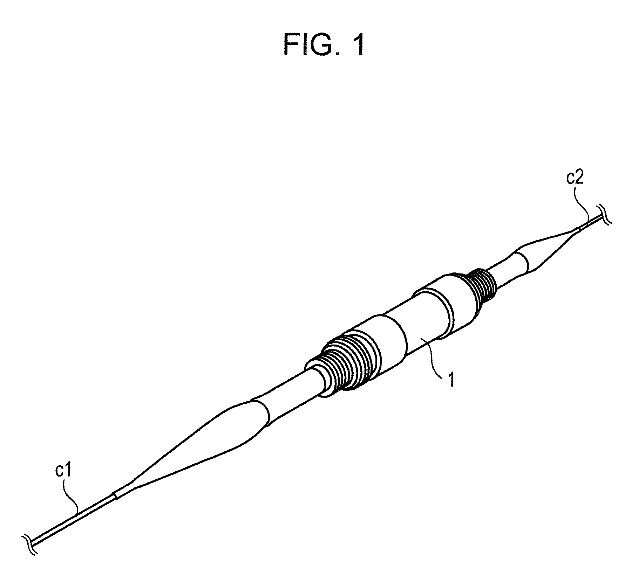

A structure of a submarine apparatus according to an embodiment of the present application is described first. FIG. 1 is a perspective view of the external appearance of a submarine apparatus 1. As illustrated in FIG. 1, both ends of the submarine apparatus 1 are connected to other submarine apparatuses through submarine cables c1 and c2. The submarine apparatus 1 includes an internal unit and a pressure-resistant housing that protects the internal unit from water pressure. The internal unit includes a unit desired to radiate heat, which is hereinafter referred to as a "heat radiation unit".

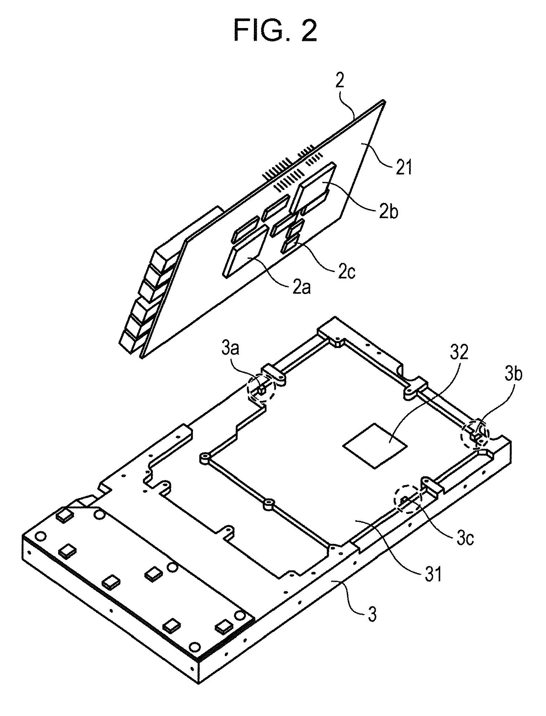

FIG. 2 is an exploded perspective view of the heat radiation unit in the submarine apparatus 1. As illustrated in FIG. 2, the heat radiation unit is structured by attaching a circuit board 2 to a heat-transfer plate 3. A plurality of heating components 2a, 2b, and 2c are mounted on a heating component mounting surface 21 of the circuit board 2. The heat-transfer plate 3 includes a thermally-conductive resin pool 31 in a surface to which the circuit board 2 is attached. The thermally-conductive resin pool 31 includes a depression 32 for a component with a large height, such as the heating component 2b, in which the component with a large height is fitted, and includes three height check portions 3a, 3b, and 3c. For example, the heat radiation unit may have a width of approximately 200 mm, a depth of approximately 250 mm, and a height of approximately 20 mm.

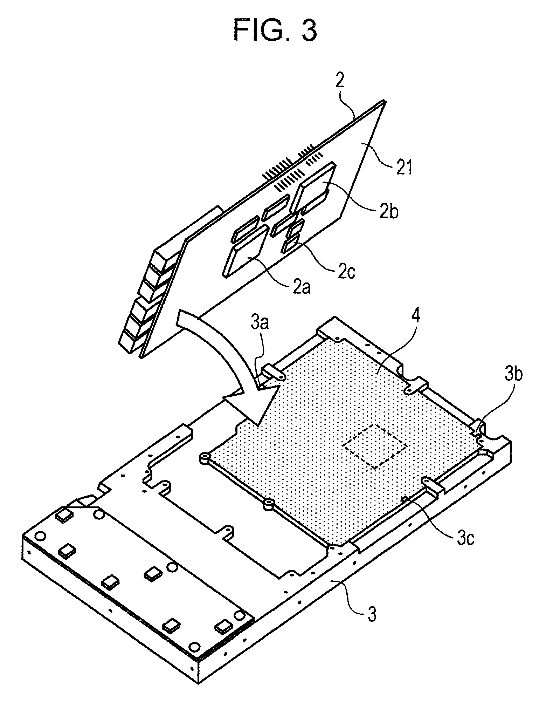

FIG. 3 illustrates how the circuit board 2 of the heat radiation unit is attached to the heat-transfer plate 3. In assembling the heat radiation unit, thermally-conductive resin 4 is poured into the thermally-conductive resin pool 31 as illustrated in FIG. 3 immediately before attaching the circuit board 2 to the heat-transfer plate 3. After the pouring, the circuit board 2 is attached to the heat-transfer plate 3 supplied with the thermally-conductive resin 4. Accordingly, the heating components 2a, 2b, and 2c on the circuit board 2 are in contact with the thermally-conductive resin 4. As a result, heat from each of the heating components 2a, 2b, and 2c is transferred to the heat-transfer plate 3 via the thermally-conductive resin 4 and radiated toward the outside of the housing.

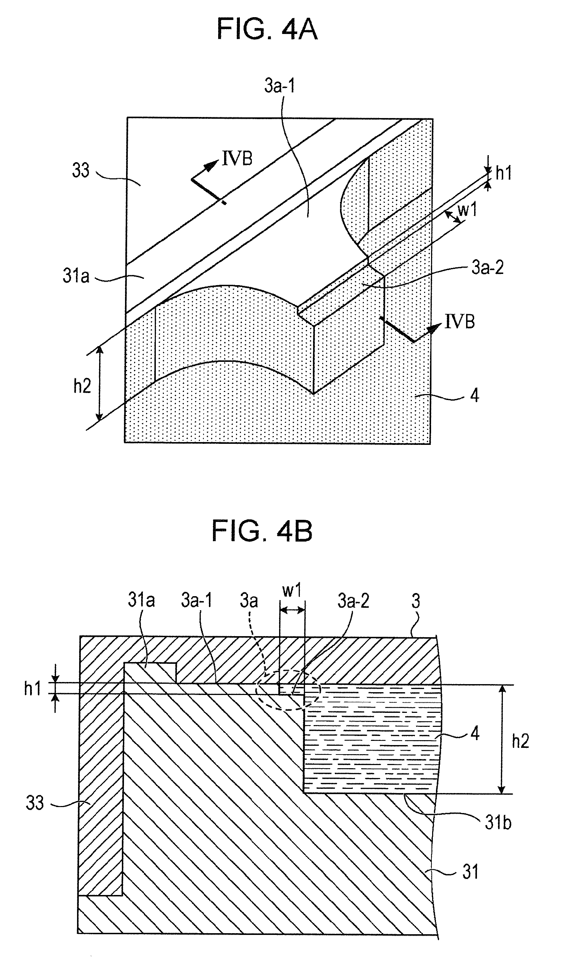

Referring to FIGs. 4A to 6C, the embodiments of the above-described heat radiation unit are described in more detail below.

### First Embodiment

FIG. 4A is an enlarged perspective view of a height check portion 3a of a heat-transfer plate 3 according to a first embodiment. As illustrated in FIG. 4A, the height check portion 3a for checking the liquid level of poured thermally-conductive resin 4 is provided to a pool outer edge portion 31a of a thermally-conductive resin pool 31 of the heat-transfer plate 3 so as to be a projection. FIG. 4B is an enlarged IVB-IVB cross sectional view of the height check portion 3a of the heat-transfer plate 3 according to the first embodiment. As illustrated in FIG. 4B, the height check portion 3a is formed so as to have two stairs. The height check portion 3a is positioned between the pool outer edge portion 31a and a pool bottom surface portion 31b, and includes an upper stair surface portion 3a-1 and a lower stair surface portion 3a-2. The upper stair surface portion 3a-1 is formed at a height corresponding to an upper limit value of the liquid level, and the lower stair surface portion 3a-2 is formed at a height corresponding to a lower limit value of the liquid level.

In the process of pouring the thermally-conductive resin 4 into the thermally-conductive resin pool 31, a person who manufactures the submarine apparatus 1 uses the three height check portions 3a, 3b, and 3c and adjusts a tilt by causing the liquid level of the poured thermally-conductive resin 4 with an amount that has been measured in advance to be found between the upper stair surface portion 3a-1 and the lower stair surface portion 3a-2 so that the heat-transfer plate 3 is kept horizontal. Although FIGs. 4A and 4B illustrate the height check portion 3a only, the other height check portions 3b and 3c also include similar stair surfaces, that is, the height check portion 3b includes an upper stair surface portion 3b-1 and a lower stair surface portion 3b-2, and the height check portion 3c includes an upper stair surface portion 3c-1 and a lower stair surface portion 3c-2. Thus, a suitable amount of the thermally-conductive resin 4 is horizontally accumulated in the thermally-conductive resin pool 31. It may be advisable to provide at least three height check portions to the pool outer edge portion 31a so as to check of horizontality of the heat-transfer plate 3.

If the thermally-conductive resin 4 is accumulated beyond the upper stair surface portion 3a-1 even while the liquid surface of the thermally-conductive resin 4 is horizontal as a result of the above-described adjustment, the liquid level exceeds the upper limit value. In this case, the volume of the thermally-conductive resin 4 may be larger than the original volume that has been measured in advance because an air bubble (air) is contained in pouring the thermally-conductive resin 4, or for another reason. In particular, when all of the upper stair surface portions 3a-1, 3b-1, and 3c-1 of the height check portions 3a to 3c are covered with the thermally-conductive resin 4, it is highly likely that the thermally-conductive resin 4 filled in the thermally-conductive resin pool 31 contains an air bubble.

Since the thermal conductivity of air is lower than the thermal conductivity of the thermally-conductive resin 4, the presence of an air bubble in the thermally-conductive resin 4 may reduce the heat radiation effect of the heat radiation unit. Thus, a person who manufactures the submarine apparatus 1 removes the air bubble using a deaerator or the like by causing the thermally-conductive resin 4 in the thermally-conductive resin pool 31 to oscillate or performing the pouring process again.

Although FIG. 4B illustrates a case in which the liquid level of the thermally-conductive resin 4 is approximately the same as the height of the upper stair surface portion 3a-1, which defines the upper limit value of the liquid level, the liquid level of the thermally-conductive resin 4 and the height of the upper stair surface portion 3a-1 may differ. That is, it is desired that the liquid level of the thermally-conductive resin 4 is approximately at a height that does not exceed the height of the upper stair surface portion 3a-1 but exceeds the height of the lower stair surface portion 3a-2. In order to perform the tilt adjustment of the liquid surface with high precision, it is further desired that a difference h1 between the height of the upper stair surface portion 3a-1 and the height of the lower stair surface portion 3a-2, which corresponds to the tolerance of the liquid level, has a small value within a range in which a visual check on whether or not the lower stair surface portion 3a-2 is covered with the thermally-conductive resin 4 is possible. The difference h1 between the height of the upper stair surface portion 3a-1 and the height of the lower stair surface portion 3a-2 may have a value between approximately 0.5 mm and 3 mm, such as 1 mm. Liquid elevation h2 based on the pool bottom surface portion 31b may indicate approximately 5 mm for example.

A width w1 of the lower stair surface portion 3a-2 is decided by taking account of the influence of surface tension of the thermally-conductive resin 4, the possibility or impossibility of the visual check on that the lower stair surface portion 3a-2 is covered with the thermally-conductive resin 4, or the like, and may have a value between approximately 2 mm and 3 mm for example.

A good conductor, such as copper or aluminum, is preferably used as a material for the heat-transfer plate 3 so as to obtain a high heat radiation effect. In view of the amount of the heat to be transferred, the weight, and the costs, a metal, such as stainless steel, a titanium alloy, or beryllium copper, may also be used. Further, a resin material that has a high heat conductivity and causes no outgas may also be used.

As described above, the submarine apparatus 1 includes the circuit board 2 and the heat-transfer plate 3. The heating components 2a, 2b, and 2c are mounted on the circuit board 2. The heat-transfer plate 3 radiates the heat of the heating components 2a, 2b, and 2c mounted on the circuit board 2. The heat-transfer plate 3 includes the thermally-conductive resin pool 31 and the height check portion 3a. The thermally-conductive resin 4 that transfers the heat of the heating components 2a, 2b, and 2c to the heat-transfer plate 3 is poured into the thermally-conductive resin pool 31. The height check portion 3a is provided to the thermally-conductive resin pool 31 so that the liquid level of the thermally-conductive resin 4 may be visually checked, and includes the upper stair surface portion 3a-1 and the lower stair surface portion 3a-2 that are formed like stairs at positions lower than the pool outer edge portion 31a and higher than the pool bottom surface portion 31b. When the thermally-conductive resin 4 is normally filled in the thermally-conductive resin pool 31, the lower stair surface portion 3a-2 of the height check portion 3a is covered with the thermally-conductive resin 4 while the upper stair surface portion 3a-1 of the height check portion 3a is exposed without being covered with the thermally-conductive resin 4.

The volume and weight of the thermally-conductive resin 4 are measured using a graduated cylinder or a beaker before the thermally-conductive resin 4 is filled in the thermally-conductive resin pool 31. Thus, when after the filling, the liquid surface of the thermally-conductive resin 4 is found between the upper stair surface portions 3a-1, 3b-1, and 3c-1 and the lower stair surface portions 3a-2, 3b-2, and 3c-2, which are included in the height check portions 3a to 3c at three locations, it may be determined that the thermally-conductive resin 4 is filled without being tilted. Accordingly, a person who manufactures the submarine apparatus 1 may determine whether or not the thermally-conductive resin 4 is normally filled by visually checking that the upper stair surface portions 3a-1, 3b-1, and 3c-1 are exposed without being covered with the thermally-conductive resin 4 and that the lower stair surface portions 3a-2, 3b-2, and 3c-2 are covered with the thermally-conductive resin 4.

When the liquid surface of the thermally-conductive resin 4 exceeds the heights of the upper stair surface portions 3a-1, 3b-1, and 3c-1 of the height check portions 3a to 3c at the three locations after the filling, it is highly likely that the liquid surface rises by an amount of the air bubbles that the thermally-conductive resin 4 contains while being filled. Accordingly, a person who manufactures the submarine apparatus 1 may determine whether or not the thermally-conductive resin 4 contains an air bubble by visually checking whether or not the upper stair surface portions 3a-1, 3b-1, and 3c-1 are covered with the thermally-conductive resin 4 in addition to the visual check on the lower stair surface portions 3a-2, 3b-2, and 3c-2.

As described above, based on the height of the liquid surface of the thermally-conductive resin 4, a person who manufactures the submarine apparatus 1 may easily and accurately check that the thermally-conductive resin 4 is horizontally filled in the thermally-conductive resin pool 31 immediately before attaching the circuit board 2 to the heat-transfer plate 3. Also, based on the height of the liquid surface of the thermally-conductive resin 4, a person who manufactures the submarine apparatus 1 may easily and accurately check that the filled thermally-conductive resin 4 contains no air bubbles. Thus, even when a large number of heating components, such as SMD components, which are smaller in height than IMD components, are mounted on the circuit board 2, the possibility of failing to immersing the heating components in the thermally-conductive resin 4 may be reduced. Further, the possibility of immersing the heating components in the thermally-conductive resin 4 that contains an air bubble may be reduced. Accordingly, a person who manufactures the submarine apparatus 1 may obtain the submarine apparatus 1 that includes a heat radiation unit with a high radiation quality. As a result, the reliability of the submarine apparatus 1 may increase.

### Second Embodiment

In the first embodiment, the height check portions 3a to 3c are formed so as to project from the pool outer edge portion 31a of the thermally-conductive resin pool 31. In a second embodiment, height check portions 3a to 3c are formed like islands apart from a pool outer edge portion 31a.

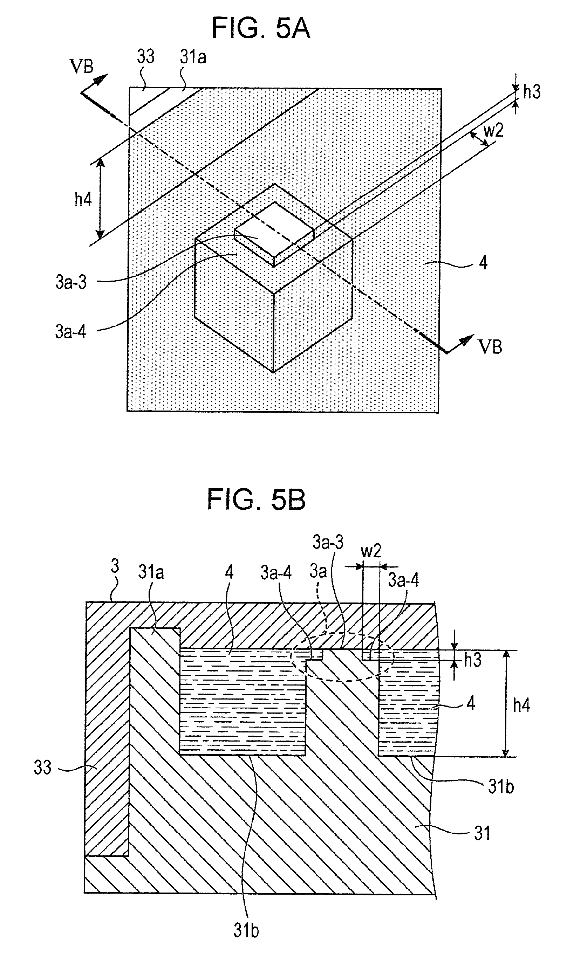

FIG. 5A is an enlarged perspective view of the height check portion 3a of a heat-transfer plate 3 according to the second embodiment. As illustrated in FIG. 5A, the height check portion 3a for checking the liquid level of poured thermally-conductive resin 4 is formed like a small isolated island near the pool outer edge portion 31a of a thermally-conductive resin pool 31 of the heat-transfer plate 3. FIG. 5B is an enlarged VB-VB cross sectional view of the height check portion 3a of the heat-transfer plate 3 according to the second embodiment. As illustrated in FIG. 5B, the height check portion 3a is formed so as to have two stairs. The height check portion 3a is positioned between the pool outer edge portion 31a and a pool bottom surface portion 31b and includes an upper stair surface portion 3a-3 and a lower stair surface portion 3a-4. The upper stair surface portion 3a-3 is formed at a height corresponding to an upper limit value of the liquid level, and the lower stair surface portion 3a-4 is formed at a height corresponding to a lower limit value of the liquid level.

In the process of pouring the thermally-conductive resin 4 into the thermally-conductive resin pool 31, a person who manufactures the submarine apparatus 1 uses the three height check portions 3a, 3b, and 3c and adjusts a tilt by causing the liquid level of the poured thermally-conductive resin 4 with an amount that has been measured in advance to be found between the upper stair surface portion 3a-3 and the lower stair surface portion 3a-4 so that the heat-transfer plate 3 is kept horizontal. Although FIGs. 5A and 5B illustrate the height check portion 3a only, the other height check portions 3b and 3c also include similar stair surfaces. Thus, a suitable amount of the thermally-conductive resin 4 is horizontally accumulated in the thermally-conductive resin pool 31.

Although FIG. 5B illustrates a case in which the liquid level of the thermally-conductive resin 4 is approximately the same as the height of the upper stair surface portion 3a-3, which defines the upper limit value of the liquid level, the liquid level of the thermally-conductive resin 4 and the height of the upper stair surface portion 3a-3 may differ and it is desired that the liquid level of the thermally-conductive resin 4 is approximately at a height that does not exceed the height of the upper stair surface portion 3a-3 but exceeds the height of the lower stair surface portion 3a-4. In order to perform the tilt adjustment of the liquid surface with high precision, it is further desired that a difference h3 between the height of the upper stair surface portion 3a-3 and the height of the lower stair surface portion 3a-4, which corresponds to the tolerance of the liquid level, has a small value within a range in which a visual check on whether or not the lower stair surface portion 3a-4 is covered with the thermally-conductive resin 4 is possible, such as approximately 1 mm. For example, liquid elevation h4 based on the pool bottom surface portion 31b may indicate approximately 5 mm. A width w2 of the lower stair surface portion 3a-4 is decided by taking account of the influence of surface tension of the thermally-conductive resin 4, the possibility or impossibility of the visual check on that the lower stair surface portion 3a-4 is covered with the thermally-conductive resin 4, or the like, and may have a value between approximately 2 mm to 3 mm for example.

Further, although FIGs. 5A and 5B illustrate a case in which the height check portion 3a is a rectangular parallelepiped, the shape is not limited to a rectangular parallelepiped but may be another, such as a cylinder or a triangle pole. Moreover, the shapes of the upper stair portion that forms the upper stair surface portion 3a-3 and the lower stair portion that forms the lower stair surface portion 3a-4 may differ. For example, when the lower stair portion is a rectangular parallelepiped, the upper stair portion may have a cylindrical shape.

### Third Embodiment

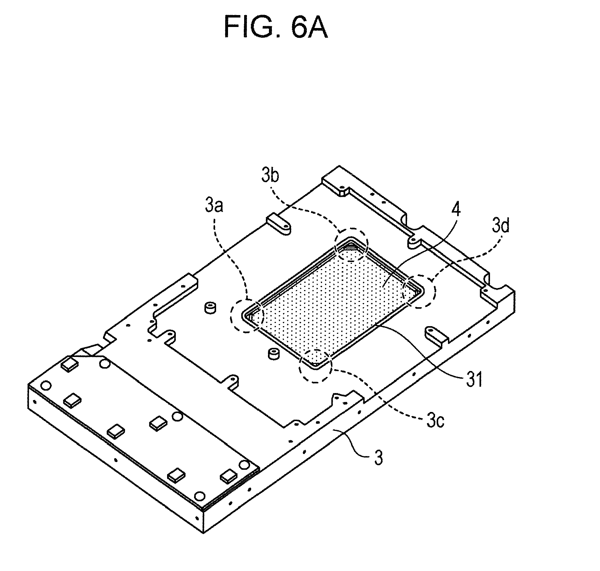

FIG. 6A is a perspective view of the external appearance of the heat-transfer plate 3 according to a third embodiment. In the second embodiment, the height check portions 3a to 3c are formed like islands apart from the pool outer edge portion 31a. In the third embodiment, as illustrated in FIG. 6A, height check portions 3a to 3d are formed at four respective corners of a thermally-conductive resin pool 31. Since only corner portions of the thermally-conductive resin pool 31 are sufficient for the height check portions 3a to 3d to be arranged, the heat-transfer plate 3 according to the third embodiment is preferable for a case in which heating components on a circuit board 2 are arranged so as to be gathered in a small area and the area of the thermally-conductive resin pool 31 is small.

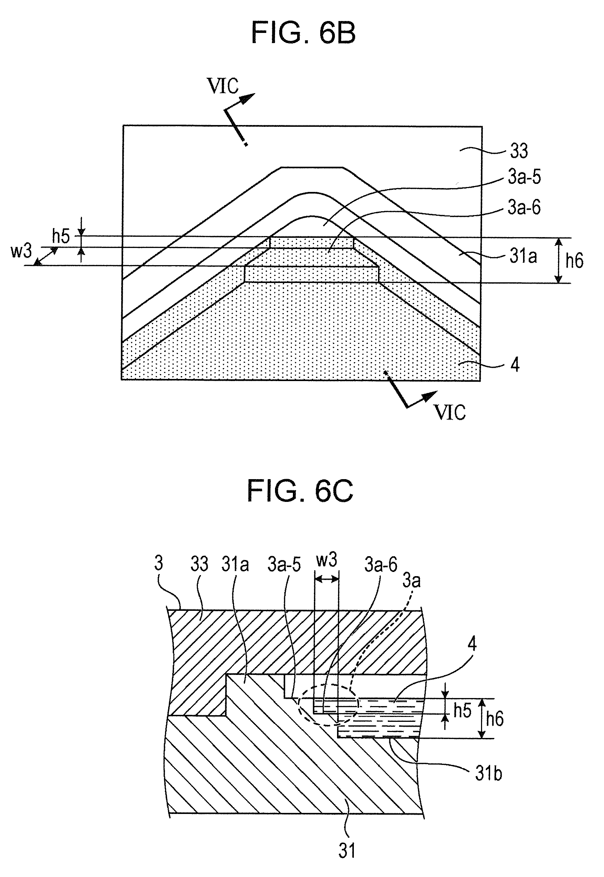

FIG. 6B is an enlarged perspective view of the height check portion 3a of the heat-transfer plate 3 according to the third embodiment. As illustrated in FIG. 6B, the height check portion 3a for checking the liquid level of poured thermally-conductive resin 4 is formed at one corner of a pool outer edge portion 31a of the heat-transfer plate 3. FIG. 6C is an enlarged VIC-VIC cross sectional view of the height check portion 3a of the heat-transfer plate 3 according to the third embodiment. As illustrated in FIG. 6C, the height check portion 3a is formed so as to have two stairs. The height check portion 3a is positioned between the pool outer edge portion 31a and a pool bottom surface portion 31b and includes an upper stair surface portion 3a-5 and a lower stair surface portion 3a-6. The upper stair surface portion 3a-5 is formed at a height corresponding to an upper limit value of the liquid level, and the lower stair surface portion 3a-6 is formed at a height corresponding to a lower limit value of the liquid level.

In the process of pouring the thermally-conductive resin 4 into the thermally-conductive resin pool 31, a person who manufactures the submarine apparatus 1 uses the four height check portions 3a, 3b, 3c, and 3d and adjusts a tilt by causing the liquid level of the poured thermally-conductive resin 4 with an amount that has been measured in advance to be found between the upper stair surface portion 3a-5 and the lower stair surface portion 3a-6 so that the heat-transfer plate 3 is kept horizontal. Although FIGs. 6B and 6C illustrate the height check portion 3a only, the other height check portions 3b, 3c, and 3d include similar stair surfaces. Thus, a suitable amount of the thermally-conductive resin 4 is horizontally accumulated in the thermally-conductive resin pool 31.

Although FIG. 6C illustrates a case in which the liquid level of the thermally-conductive resin 4 is approximately the same as the height of the upper stair surface portion 3a-5, which defines the upper limit value of the liquid level, the liquid level of the thermally-conductive resin 4 and the height of the upper stair surface portion 3a-5 may differ and it is desired that the liquid level of the thermally-conductive resin 4 is approximately at a height that does not exceed the height of the upper stair surface portion 3a-5 but exceeds the height of the lower stair surface portion 3a-6. In order to perform the tilt adjustment of the liquid surface with high precision, it is further desired that a difference h5 between the height of the upper stair surface portion 3a-5 and the height of the lower stair surface portion 3a-6, which corresponds to the tolerance of the liquid level, has a small value within a range in which a visual check on whether or not the lower stair surface portion 3a-6 is covered with the thermally-conductive resin 4 is possible, such as approximately 1 mm. Liquid elevation h6 based on the pool bottom surface portion 31b may indicate approximately 5 mm for example. A width w3 of the lower stair surface portion 3a-6 is decided by taking account of the influence of surface tension of the thermally-conductive resin 4, whether or not the possibility or impossibility of the visual check on that the lower stair surface portion 3a-6 is covered with the thermally-conductive resin 4, or the like, and may have a value between approximately 2 mm and 3 mm for example.

In each of the above-described embodiments, the height check portions are formed at three or four locations of the heat-transfer plate 3. Since the horizontal surface is established by three points, it is desirable in view of cost-benefit performance that the height check portions 3a, 3b, 3c, and 3d are formed at three or more locations but the height check portions may be formed at two locations.

Also as to the positions at which the height check portions are formed, the height check portions 3a, 3b, 3c, and 3d may be arranged so as to adjoin the pool outer edge portion 31a as described in the first embodiment and the third embodiment, or may be arranged apart from the pool outer edge portion 31a by a certain distance or more as described in the second embodiment. Further, also as to the positional relation among the plurality of height check portions 3a, 3b, 3c, and 3d, the height check portions 3a, 3b, 3c, and 3d may be arranged away from one another so as to ensure gaps that each have a certain value or more, or may be arranged so as to be gathered in a certain region. Depending on a jig, the heat-transfer plate 3 may employ a structure in which all of the height check portions are arranged near the center of the thermally-conductive resin pool 31.

Further, the number of stairs formed in the height check portions 3a, 3b, 3c, and 3d is not limited to two but may be three or more only when it is possible to check that the upper stair surface portions are exposed and the lower stair surface portions are covered with the thermally-conductive resin 4.

In the description above, the structures according to the embodiments are explained separately. However, the heat-transfer plate 3 according to each embodiment may include another constituent unique to the other embodiments. Further, the embodiments may be combined as desired, that is, the number of combinations of the embodiments is not limited to two but may be three or more. For example, the island-like height check portion according to the second embodiment or the height check portion at the corner according to the third embodiment may be added to the thermally-conductive resin pool 31 of the heat-transfer plate 3 according to the first embodiment. Moreover, the height check portion 3a may be provided so as to project from the pool outer edge portion 31a and the height check portion 3b may be formed in the thermally-conductive resin pool 31 like an island while the height check portion 3c is provided at a corner of the pool outer edge portion 31a.

## Claims

1. A heat radiation plate (3) suitable for having a circuit board (2) attached to said heat radiation plate (3) and configured to radiate heat of an electronic component (2a-2c) mounted on the circuit board (2) when the circuit board (2) is attached to the heat radiation plate (3), the heat radiation plate (3) comprising a depressed portion (31) into which thermally-conductive resin (4) is filled, the resin being suitable for transferring the heat of the electronic component (2a-2c) when immersed in the resin to the heat radiation plate (3),
**characterized in that**:
the heat radiation plate (3) comprises a plurality of check portions (3a-3d) configured to be provided to the depressed portion (31) and with an upper surface portion (3a-1, 3a-3, 3a-5) and a lower surface portion (3a-2, 3a-4, 3a-6) stepwise at positions lower than an outer edge portion (31a) of the depressed portion (31) and higher than a bottom surface portion (31b) of the depressed portion (31) so that a liquid level of the thermally-conductive resin (4) is visually checkable, and
when the thermally-conductive resin (4) is normally filled in the depressed portion (31), each of the lower surface portions (3a-2, 3a-4, 3a-6) of the plurality of check portions (3a-3d) is covered with the thermally-conductive resin (4) and each of the upper surface portions (3a-1, 3a-3, 3a-5) of the plurality of check portions (3a-3d) is exposed without being covered with the thermally-conductive resin (4).

2. The heat radiation plate (3) according to claim 1, wherein the plurality of check portions (3a-3d) are provided at three or more locations in the depressed portion (31).

3. The heat radiation plate (3) according to claim 1, wherein the plurality of check portions (3a-3d) are provided at positions apart from the outer edge portion (31a) of the depressed portion (31).

4. The heat radiation plate (3) according to claim 1, wherein the plurality of check portions (3a-3d) are provided in corner portions of the outer edge portion (31a) of the depressed portion (31).

5. A submarine apparatus (1) comprising:
a circuit board (2) on which an electronic component (2a-2c) is mounted; and
a heat radiation plate (3) according to any one of the preceding claims.

## Patentansprüche

1. Wärmestrahlungsplatte (3), die dazu geeignet ist, eine Leiterplatte (2) an sich angebracht aufzuweisen, und dazu ausgestaltet ist, Wärme einer elektronischen Komponente (2a-2c) abzustrahlen, die an der Leiterplatte (2) montiert ist, wenn die Leiterplatte (2) an der Wärmestrahlungsplatte (3) angebracht ist, wobei die Wärmestrahlungsplatte (3) einen vertieften Abschnitt (31) umfasst, in welchen ein thermisch leitender Kunststoff (4) gefüllt ist, wobei der Kunststoff geeignet ist die Wärme der elektronischen Komponente (2a-2c), wenn diese in den Kunststoff eingesetzt ist, zu der Wärmestrahlungsplatte (3) zu übertragen, **dadurch gekennzeichnet, dass**:
die Wärmestrahlungsplatte (3) mehrere Kontrollabschnitte (3a-3d) umfasst, die dazu ausgestaltet sind, in dem vertieften Abschnitt (31) und mit einem oberen Oberflächenabschnitt (3a-1, 3a-3, 3a-5) und einem unteren Oberflächenabschnitt (3a-2, 3a-4, 3a-6) schrittweise an Positionen unterhalb eines äußeren Kantenabschnitts (31a) des vertieften Abschnitts (31) und höher als ein Bodenoberflächenabschnitt (31b) des vertieften Abschnitts (31) bereitgestellt zu werden, sodass ein Flüssigkeitspegel des thermisch leidenden Kunststoffs (4) visuell prüfbar ist, und,
wenn der thermisch leitende Kunststoff (4) normal in einem vertieften Abschnitt (31) gefüllt ist, jeder der unteren Oberflächenabschnitte (3a-2, 3a-4, 3a-6) der mehreren Prüfabschnitte (3a-3d) mit den thermisch leitenden Kunststoff (4) bedeckt ist und jeder der oberen Oberflächenabschnitte (3a-1, 3a-3, 3a-5) der mehreren Prüfabschnitte (3a-3d) freiliegt, ohne mit dem thermisch leitenden Kunststoff (4) bedeckt zu sein.

2. Wärmestrahlungsplatte (3) nach Anspruch 1, wobei die mehreren Prüfabschnitte (3a-3d) an drei oder mehr Orten in dem vertieften Abschnitt (31) bereitgestellt sind.

3. Wärmestrahlungsplatte (3) nach Anspruch 1, wobei die mehreren Prüfabschnitte (3a-3d) an Positionen getrennt von dem äußeren Kantenabschnitt (31a) des vertieften Abschnitts (31) bereitgestellt sind.

4. Wärmestrahlungsplatte (3) nach Anspruch 1, wobei die mehreren Prüfabschnitte (3a-3d) in Eckabschnitten des äußeren Kantenabschnitts (31a) des vertieften Abschnitts (31) bereitgestellt sind.

5. Unterwasservorrichtung (1), umfassend:
eine Leiterplatte (2), an welcher eine elektronische Komponente (2a-2c) montiert ist; und
eine Wärmestrahlungsplatte (3) entsprechend einem der vorhergehenden Ansprüche.

## Revendications

1. Plaque de rayonnement de chaleur (3) appropriée pour présenter une plaquette à circuits imprimés (2) fixée à ladite plaque de rayonnement de chaleur (3) et configurée pour faire rayonner de la chaleur d'un constituant électronique (2a-2c) fixé sur la plaquette à circuits imprimés (2) lorsque la plaquette à circuits imprimés (2) est fixée à la plaque de rayonnement de chaleur (3), la plaque de rayonnement de chaleur (3) comprenant une portion en creux (31) dans laquelle une résine thermiquement-conductrice (4) est introduite, la résine étant appropriée pour transférer la chaleur du constituant électronique (2a-2c) lorsqu'il est immergé dans la résine vers la plaque de rayonnement de chaleur (3),
**caractérisée en ce que** :
la plaque de rayonnement de chaleur (3) comprend plusieurs portions de contrôle (3a-3d) configurées pour être fournies dans la portion en creux (31) et avec une portion de surface supérieure (3a-1, 3a-3, 3a-5) et une portion de surface inférieure (3a-2, 3a-4, 3a-6) en étages à des positions inférieures à une portion de bord externe (31a) de la portion en creux (31) et supérieures à une portion de surface de fond (31b) de la portion en creux (31) de sorte qu'un niveau liquide de la résine thermiquement conductrice (4) peut être visuellement contrôlé, et
lorsque la résine thermiquement-conductrice (4) est normalement introduite dans la portion en creux (31), chacune des portions de surfaces inférieures (3a-2, 3a-4, 3a-6) des plusieurs portions de contrôle (3a-3d) est recouverte avec la résine thermiquement-conductrice (4) et chacune des portions de surfaces supérieures (3a-1, 3a-3, 3a-5) des plusieurs portions de contrôle (3a-3d) est exposée sans être recouverte avec la résine thermiquement-conductrice (4).

2. Plaque de rayonnement de chaleur (3) selon la revendication 1, dans laquelle les plusieurs portions de contrôle (3a-3d) sont fournies à trois endroits ou plus dans la portion en creux (31).

3. Plaque de rayonnement de chaleur (3) selon la revendication 1, dans laquelle les plusieurs portions de contrôle (3a-3d) sont fournies à des positions éloignées de la portion de bord externe (31a) de la portion en creux (31).

4. Plaque de rayonnement de chaleur (3) selon la revendication 1, dans laquelle les plusieurs portions de contrôle (3a-3d) sont fournies dans des portions de coins de la portion de bord externe (31a) de la portion en creux (31).

5. Appareil de sous-marin (1) comprenant :
une plaquette à circuits imprimés (2) sur laquelle un constituant électronique (2a-2c) est fixé ; et
une plaque de rayonnement de chaleur (3) selon l'une quelconque des revendications précédentes.
